# EUROPÄISCHE PATENTSCHRIFT

(11) **EP 1 565 657 B1**
(45) Veröffentlichungstag und Bekanntmachung des Hinweises auf die Patenterteilung: **27.12.2006**
(21) Anmeldenummer: 03767425.6
(22) Anmeldetag: 13.11.2003
(51) Int. Cl.: F15B 11/072

(54) **HOCHDRUCKVORRICHTUNG FÜR REINRAUMANWENDUNGEN**
HIGH PRESSURE DEVICE FOR CLEAN ROOM APPLICATIONS
DISPOSITIF A HAUTE PRESSION POUR APPLICATIONS EN SALLE BLANCHE

(30) Priorität: 26.11.2002 DE 10255230
(43) Veröffentlichungstag der Anmeldung: 24.08.2005
(73) Patentinhaber: Uhde High Pressure Technologies GmbH, 58093 Hagen (DE)
(72) Erfinder: LÜTGE, Christoph, 59425 Unna (DE); KURTZ, Hans-Ottomar, 44139 Dortmund (DE)
(86) Internationale Anmeldenummer: PCT/DE2003/003755
(87) Internationale Veröffentlichungsnummer: WO 2004/048782

(56) Entgegenhaltungen:
- WO-A-01/69088
- DE-A- 4 022 159
- DE-A- 10 026 616
- US-A- 3 721 091
- US-A- 5 377 488

## Beschreibung

Die Erfindung betrifft eine Vorrichtung zum Verschließen eines Behälters beziehungsweise zum Verformen oder Pressen eines Halbzeuges für Reinraumanwendungen, mittels eines rotationssymmetrischen Hubsystems in einer sehr kompakten Bauform, welche einen bewegten Arbeitskolben und einen bewegten Verstärkerkolben enthält, die jeweils in Zylindern geführt werden. Dabei können regelmäßig und mit hoher Frequenz 180 bar und mehr an dem Kopf des Arbeitskolbens erreicht werden. Der Arbeitskolben wird wasserhydraulisch und der Verstärkerkolben pneumatisch angetrieben, wobei diese beiden über ein Fluid, welches sich in einem Hohlraum zwischen Bodenfläche des Arbeitszylinders und Stirnseite des Verstärkerkolbens befindet, in direkter axialer Wirkverbindung stehen. Die Stirnseite des Arbeitskolbens bildet dabei mindestens zum Teil den Verschluss des Behälters oder ist starr mit einem Verschlussteil des Behälters verbunden beziehungsweise bildet die Stirnseite des Arbeitskolbens das Werkzeug oder ist starr mit dem Werkzeug verbunden.

In der Halbleiterfertigung, der opto-elektronischen Industrie und in anderen Industriezweigen werden immer mehr Produkte entwickelt, die zentrale Funktionen mittels oder auf Basis von Mikro- oder Nanostrukturen realisieren. Diese Mikro- und Nanostrukturen sind vor allem während ihrer Produktion extrem empfindlich gegenüber geringsten Verunreinigungen, Daher werden an die Komponenten der Fertigungsverfahren höchste Ansprüche bzgl. der zulässigen Emissionen gestellt. Die erforderlichen Reinigungsschritte für nanostrukturierte Oberflächen sind z. T. mit üblichen Reinigungsflüssigkeiten nicht mehr oder nur sehr schwer möglich. Seit einiger Zeit werden in großem Maßstab daher überkritische Fluide eingesetzt, die verbesserte Benetzungs- und Reinigungseigenschaften aufweisen. Hierfür sind Prozessdrücke von 150 bis über 300 bar erforderlich, die besondere Ausrüstungen erfordern. Mechanisch geeignete Hochdruckaggregate waren bisher nicht oder nicht direkt reinraumtauglich. Die vorliegende Erfindung beschreibt ein Hochdruckaggregat für den Einsatz im Reinraum, welches bei schnellem Lastwechsel auf hohem Druckniveau nur geringste Emissionen erzeugt und in einer sehr kompakten Bauform ausgeführt ist.

Hubaggregate für Drücke über 150 bar sind in vielfältigem technischen Einsatz und in der Patent- und Fachliteratur hinreichend beschrieben.

Ebenfalls aus der Literatur bekannt sind Hubaggregate, die unter anderem Arbeitskolben und Verstärkerkolben enthalten, wobei die Stirnfläche des Verstärkerkolbens axial auf ein Arbeitsmedium einwirkt, welches im Zylinderraum unterhalb der Bodenfläche des Arbeitskolbens eingeschlossen ist und Arbeitshub oder Endkraft des Arbeitskolbens bewirkt.

Die Schriften DE 100 26 616 A1 und WO 01/69088 A1 beschreiben vorgenannte Hubsysteme, in denen das Arbeitsmedium des Arbeitskolbens und das des Druckübersetzers identisch ist. JP 55126103 offenbart ein derartiges Hubsystem, das mit einem zusätzlichen Behälter ausgestattet ist, in dem verdrängte Hydraulikflüssigkeit temporär aufgefangen wird. WO 01/69088 A1 legt weiterhin eine Rückstellfunktion des Arbeitskolbens dar, die derart ausgeführt ist, dass der Plunger des Arbeitskolbens in einer Feder geführt ist, die beim Krafthub zwischen dem Zylinderkopf und dem Kolbenfuß eingespannt wird. Endet die Krafteinwirkung auf den Kolben, entspannt sich die Feder und führt den Arbeitskolben in die Ausgangsposition, das Hydraulikfluid wird dabei nicht näher bestimmt.

Ebenfalls sind aus der Literatur Hubaggregate bekannt und hinreichend beschrieben, die ein Arbeitsmedium für den Arbeitskolben vorsehen, welches unterschiedlich vom Arbeitsmedium des Verstärkerkolbens ist. Die in den Schriften JP 09280202 oder DE 199 46 678 A1 beschriebenen hydraulisch-pneumatischen Vorrichtungen seien hier beispielhaft für derartige kombinierte Hubaggregate genannt.

Hubsysteme mit hydraulisch-pneumatischen Zylinderantrieben sind ebenfalls bekannt. DE40 22 159 A1 offenbart einen Luft-Öldruckverstärkerzylinder, der einen Stößeldruckaufbringer anfänglich mit einem relativ niedrigen und anschließend mit einem zweiten höheren Betriebsdruck beliefert. Eine vergleichbares Hubsystem mit hydro-pneumatischer Drudcübersetzung wird in der US 5,377,488 offenbart, wobei ebenfalls ein Hydrauliköl als Arbeitsmedium für den endgültigen Betriebsdruck eingesetzt wird.

Es ist üblich das Fluid abhängig von der Arbeitsaufgabe des Hubsystems zu wählen. Entscheidend hierbei ist neben der Hubfrequenz, der zu erzielende Arbeits- oder Betriebsdruck.

Als Arbeitsmedien dienen Fluide und Gase, wobei bis ca. 160 bar wasserbasierte Fluide und über 160 bar vorrangig Hydrauliköle eingesetzt werden. Inerte Gase und Luft sind die üblichen gasförmigen Arbeitsmittel in noch niedrigeren Druckbereichen. Hydrauliköl weist wichtige positive Eigenschaften auf, die u. a. in der Schmierung der Gleitflächen, einer geringen Kompressibilität und hoher Temperaturbeständigkeit bestehen.

Nicht vollständig zu kompensierende nachteilige Effekte bei Kolbensystemen sind unter anderem Materialabtrag sowie Leckage des Arbeitsmediums. Reibungs- und druckbedingter Materialabtrag wie z. B. Abrieb, Verdampfung und Verflüssigung geschieht in geringem Maße an dem Basiswerkstoff selbst und vor allem am Dichtungssystem. Der Materialabtrag in Hubaggregaten ist im Wesentlichen abhängig von der Oberflächenbeschaffenheit der Gleitflächen und Fertigungstoleranzen der Bauteile, dem Dichtungsmaterial und dem radialen Anpressdruck der Dichtung sowie der Temperatur.

Die Leckage des Arbeitsmediums, welches bei jedem Krafthub in gewissen Mengen mitgeführt wird, ist unter anderem funktional von Oberflächenbeschaffenheit, Viskosität, hydrostatischem Druck im Zylinderraum sowie von der Dichtungskonstruktion und deren radialem Anpressdruck abhängig.

Hohe Arbeitsdrücke erfordern eine ausreichende Schmierung der sich berührenden und gegeneinander ablaufenden Flächen, was zu entsprechenden Leckagemengen führt. Dieser Effekt kann über geeignete Dichtungssysteme und eine hochwertige Oberflächenbearbeitung minimiert werden. Die Möglichkeit, den Anpressdruck zur Leckagerückhaltung zu erhöhen, ist allerdings dadurch begrenzt, dass mit steigendem Druck auch die Zerstörung bzw. der Abtrag des Dichtungsmaterials steigt, was ebenfalls eine Emission darstellt und nachfolgend zu erhöhten Leckagemengen führt. Des Weiteren werden die Grenzen mechanischer Belastbarkeit und einer ökonomischen Betriebsweise erreicht.

Verunreinigungen aus Materialabtrag und Leckage aus den oben genannten Quellen sind im Produktionsbereich vor allem für Reinraumprozesse sehr nachteilig. Reinheitsklassen werden z. B. in der DIN 2083 oder im Federal Standard 209D definiert. Emissionen jeglicher Art beeinflussen direkt die Produktqualität in diesen Prozessen und werden mit hohem apparativen und organisatorischen Aufwand minimiert, was mit entsprechenden Kosten verbunden ist. Besonders schwerwiegend und nachteilig sind Verunreinigungen durch Ölnebel, da ölhaltige lmmissionen häufig chemisch aktiv sind und nur mit lösungsmittelhaltigen Stoffen wieder zu entfernen sind, welche wiederum im Reinraum nicht erwünscht bzw. sehr nachteilig sind.
Es ist bekannt, dass ölhydraulische Hubsysteme im Reinraumeinsatz pröblematisch sind und durch-geeignete Absaugung für Reinraumanwendungen tauglich gemacht werden können (SWISS Contamination Control 5 (1992) Nr. 5, S. 8 ff.). Beim Einsatz eines Presswerkzeugs zur Produktion von CD-Platten traten Ölanhaftungen am Halbzeug auf. Untersuchungen ergaben, dass Quelle dieser Verunreinigung das Hydrauliköl war. Durch das Anbringen von geschlossenen Manschetten an die Schubstangen des Werkzeugs und das Absaugen des Pressengehäuses sowie der Luft aus den Manschetten, konnte die gewünschte Reinraumtauglichkeit hergestellt werden.

Ein weiterer Fachartikel offenbart einen Pneumatikzylinder in einer kolbenstangenlosen Ausführung (Dr.-Ing. E. Fritz; Schrift zum 1. Int. Forum Fluidtechnisches Kolloquium, Band 2, S. 283 ff.). Die Reinraumtauglichkeit wurde erreicht, indem im Raum zwischen Abdeckband und Dichtband ein Teilvakuum erzeugt wurde. Hierzu wurden Vakuumanschlüsse auf dem Zylinderrohr angebracht und die Emissionen abgeführt.

Nachteilig an den vorgenannten Hubaggregaten mit Absaugung ist, dass zusätzliche Systeme zur Sicherstellung minimaler Partikelkonzentrationen erforderlich sind, welche installiert und permanent betrieben werden müssen.

Für komplexere Fertigungsketten, bei denen reinraumtaugliche Komponenten gleichzeitig mit wenig geeigneten Komponenten zum Einsatz kommen, wird eine räumliche Trennung realisiert. In sogenannten "Maintenance Bereichen" werden die für den Reinraum nicht tauglichen Ausrüstungen und in sogenannten "White Rooms" die reinraumtauglichen Ausrüstungsteile untergebracht. Derartige Lösungen erfordern aufwändige Schleusen und organisatorische Vorkehrungen, um die Rückhaltung von Verunreinigungen aus dem "Maintenance Bereich" sicherzustellen.

US 6,067,728 offenbart eine Vorrichtung und ein Verfahren zur Trocknung von Waferscheiben mittels überkritischem CO₂, wobei ein pneumatischmechanisches Verschlusssystem dargelegt wird. Der Verschluss des Behälterdeckels wird über einen pneumatischen Kolben und eine Hebelvorrichtung realisiert, wobei über diese Anordnung eine Vorpressung erreicht wird. Die Verriegelung des Deckels geschieht durch Klammem. Nach dem pneumatischmechanischen Verschluss des Prozessraumes werden eine oder mehrere statische Klammem symmetrisch am Rand des Deckels positioniert. Diese Klammerverschlüsse werden mechanisch über den Rand des Behälterdeckels und des Behälterbodens geschoben und gewährleisten bei steigendem Innendruck die Dichtheit des Behälters während des Prozesses.

Nachteilig an der vorgenannten Erfindung sind die vielen bewegten Teile, welche bzgl. der Emissionen als kritisch zu betrachten sind, und welche die Hubzahl bzw. mögliche Prozesszyklen pro Zeiteinheit durch die erforderlichen Wege stark begrenzen. Die vielen Abläufe erfordern weiterhin eine aufwändige Steuerung.

Ziel ist es, zusätzliche Absaugungs- und Sicherungssysteme bzw. die räumlichen Aufteilungen durch technische Lösungen am eigentlichen Hubkolben überflüssig zu machen. Weiterhin sollen Bauformen erreicht werden, die die Erfordernisse eines sicheren Betriebes mit möglichst geringen Bewegungen und wenigen bewegten Bauteilen erzielen.

Die vorliegende Erfindung löst diese Aufgabe gemäß dem Hauptanspruch 1.

Entscheidend dabei ist, dass der Arbeitskolben hydraulisch mit Wasser und der Verstärkerkolben pneumatisch angetrieben werden und mindestens eine der Gleitflächen, welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, ein Tragverhältnis über 60 % aufweist. Das Tragverhältnis wird als Verhältnis des Anteils der Erhebungen zum Anteil der Vertiefungen in der Oberflächenstruktur definiert.

Weiterhin ist gegeben, dass
- Arbeitskolben und Verstärkerkolben über das Fluid, welches sich in einem Hohlraum zwischen Bodenfläche des Arbeitskolbens und Stirnseite des Verstärkerkolbens befindet, bezüglich der Rotationsachse in direkter axialer Wirkverbindung stehen, wobei
- die Stirnseite des Arbeitskolbens mindestens zum Teil der Verschluss des Behälters ist oder starr mit einem Verschlussteil des Behälters verbunden ist und
- dieses Verschlussteil bezogen auf den Arbeitskolben ebenfalls im Wesentlichen entlang der Rotationsachse verfahren wird und der Behälter gegenüber der Stirnseite des Arbeitskolbens angeordnet ist, und
- das Kolbensystem hinsichtlich der Zu- und Ableitung der Antiebsmedien offen ist.

In einer weiteren Ausgestaltung der Erfindung ist mindestens ein Teil der Gleitflächen gehärtet.

In einer weiteren Verfahrensführung wird in dem Zylinderraum ein anderes Fluid als Wasser verwendet, und dieses Fluid ist vorzugsweise ein leichtflüchtiges Medium oder es kommt ein Gas als Arbeitsmedium zum Einsatz. Der pneumatische Arbeitskolben kann vorteilhafterweise mit Druckluft oder einem anderen Gas oder Gasgemisch betrieben werden.

In einer weiteren vorteilhaften Variante der Verfahrensführung wird durch die Rückstellung des Arbeitskolbens Ober das im Zylinderraum eingeschlossene Fluid direkt die Rückstellung des Verstärkerkolbens realisiert, indem das Fluid auf die Stirnfläche des Verstärkerkolbens wirkt und diesen in die Ausgangsposition zurückführt.

Eine weiterführende Ausgestaftungsvariante der Verfahrensführung besteht in der Taktung des Hub- und Verschlussaggregats mit dem Prozesszyklus, welcher im Behälter durchgeführt wird.

In einer weiteren vorteilhaften Variante des Verfahrens wird regelmäßig ein Druck an der Stirnfläche des Arbeitskolbens und/oder im Behälter erreicht, der über 180 bar liegt, wobei er Druck in der Stimfläche regelmäßig mindestens gleich oder größer als der Druck im Behälter ist.

Die Erfindung beinhaltet weiterhin eine Verwendung der Vorrichtung für Prozesse, bei denen im Behälter mindestens ein überkritisches Gas zum Einsatz kommt.

Damit findet die erfindungsgernäße Vorrichtung und das Verfahren vorteilhafterweise für Prozesse Verwendung, die direkt oder indirekt im Reinraum oder in vergleichbaren Labor- oder Betriebsstätten stattfinden.

Weiterhin beinhaltet die Erfindung eine Verwendung der Vorrichtung und/oder des Verfahrens für Prozesse, die direkt oder indirekt im Zusammenhang mit mindestens einer Anwendung, Produktion oder einem Verfahren der Halbleiterindustrie und/oder Waferherstellung, der optischen Industrie sowie der pharmazeutischen und/oder medizinischen Industrie stehen.

In einer weiteren vorteilhaften Ausführung der Vorrichtung ist die Stirnseite des Arbeitskolbens als Presswerkzeug ausgebildet oder mit einem Presswerkzeug starr verbunden und dieses Presswerkzeug bezogen auf den Arbeitskolben wird ebenfalls im Wesentlichen axial verfahren. Damit ist ein Pressverfahren unter Einsatz des vorgenannten Presswerkzeuges von der Erfindung umfasst, welches für Pressvorgänge z. B. zur Formgebung, zum Kleben oder zum Materialeintrag unter Reinraumbedingungen eingesetzt wird.

Die Figuren 1 bis 4 zeigen die Vorrichtung im Längsschnitt.
- Fig. 1:: Hubsystem
- Fig. 2: Hubsystem und Ventilschaltung in der Ausgangsposition des Hubvorgangs (*"Geöffneter Behälter*")
- Fig.3: Hubsystem und Ventilschaltung nach Ende der Vorpressphase und Druckverstärker in Ausgangsposition (*"Geschlossener Behälter"*)
- Fig. 4: Hubsystem und Ventilschaltung während der Hochlastphase und Dnrckverstärtcer in Endposition (*"Verriegelter Behälter"*)

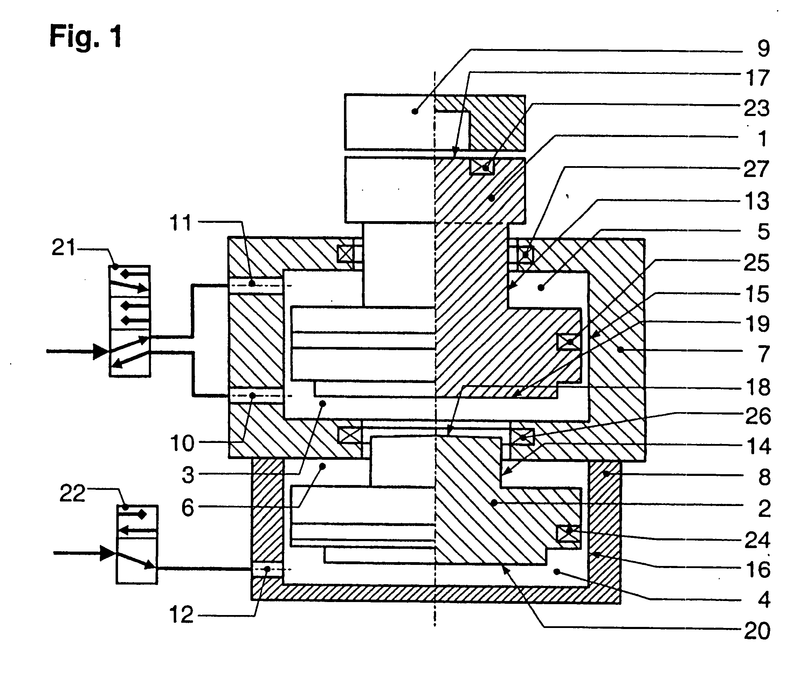

Die vorliegende Erfindung wird nachstehend anhand der weiterer Erläuterungen, von Beispielen sowie den Figuren 1 bis 4 näher beschrieben. Fig. 1 zeigt das erfindungsgemäße hydraulisch-pneumatisches Hub- und Verschlussaggregat, in welchem ein wasserhydraulischer Arbeitskolben 1 mit einem pneumatischen Verstärkerkolben 2 axial über ein Fluid, welches sich in dem Zylinderraum 3 befindet, in direkter Wirkverbindung steht. Die Stirnfläche 18 des Druckverstärkers wirkt auf das vorgenannte Fluid und ist parallel zu der Fußfläche 19 des Arbeitszylinders angeordnet. Das Stirnende, des Arbeitskolbens 1 bildet weiterhin den Verschluss des Druckbehälters 9 und ist in der vorliegenden Ausführung die Bodenplatte des Behälters 9. Die Gleitflächen 13-16 des erfindungsgemäßen Hub- und Verschlussaggregates sind derart ausgeführt, dass sie ein hohes Tragverhältnis und/oder hohe Härte aufweisen.

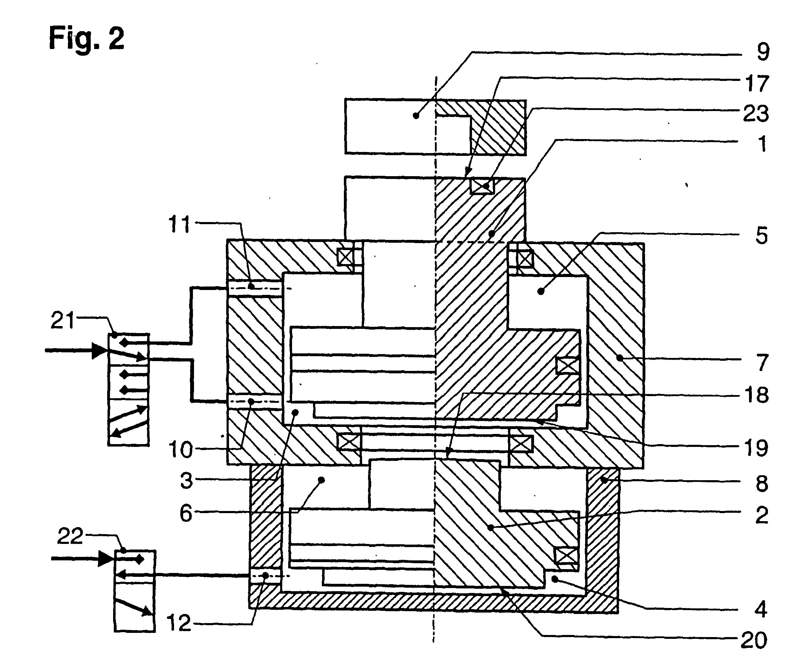

Fig. 2 bis 4 zeigen schematisch die Vorrichtung und das Verfahren, wie sie in einer Versuchsanlage im industriellen Maßstab 1:1 realisiert wurden. Über 10 Wochen wurde unter Volllast im Dauerbetrieb diese Versuchsanlage gefahren. Der Vorstelldruck in dem Zylinderraum 3 wurde aus einem größeren Wasserleitungsnetz ohne zusätzliche Druckerhöhung eingestellt und belief sich auf ca. 6 bar. Als pneumatisches Arbeitsmedium für den Zylinderraum 4 wurde N₂ aus einem Druckflaschenpaket verwendet, wobei der Druck von 25 bar durch entsprechende Entspannung erreicht wurde. Diese Versuchsvorrichtung bzw. dieses Verfahren verrichtete innerhalb von 10 Wochen ohne Unterbrechung ca. 100.000 Lastwechsel mit einem Arbeitsdruck an der Stirnseite 17 des Arbeitskolbens 1 von ca. 260 bar. In dem Versuchsaufbau wurde die Stirnseite des Arbeitskolbens 1 gegen ein Joch gefahren und bei jedem Zyklus für ca. 3 Sekunden gehalten.

Bezüglich der Vorbereitung der Gleitflächen des Werkstoffes stellte sich heraus, dass die Gleitflächen ein Tragverhältnis von Ober 60% aufweisen müssen, um ein Festfressen der Gleitflächen zu verhindern, und eine Härtung dieser Flächen vorteilhaft ist. Es wurden austenitische Werkstoffe eingesetzt, wobei diese Vorrichtung nicht auf diese Werkstoffgruppe beschränkt ist.

Die Verfahren zur Herstellung hoher Tragverhältnisse sind in der Literatur weitreichend beschrieben. Als mögliche Verfahren stehen z. B. das Honen, Läppen oder Rollieren zur Verfügung. Die Härtung der so vorbehandelten Oberflächen kann mittels Plasmanitrierung, Kolsterisierung oder Hartverchromung realisiert werden und ist ebenfalls als Stand der Technik zu betrachten und wird von Spezialfirmen kommerziell angeboten.

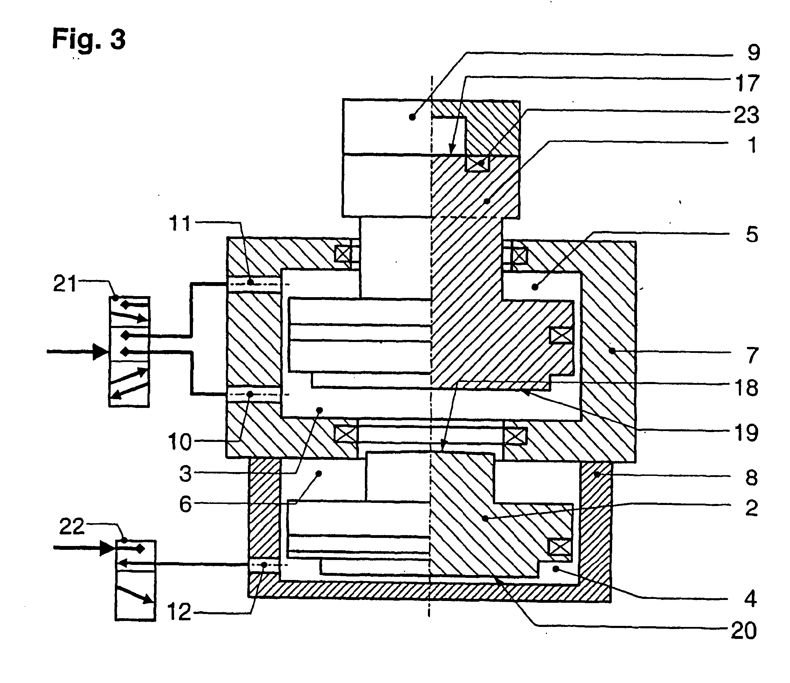

Weiterhin umfasst ist ein Verfahren zum Betrieb der erfindungsgemäßen Vorrichtung, indem ein Arbeitskolben 1 durch hydrostatischen Wasserdruck in Lastposition (Fig. 3) gefahren wird. Das Arbeitsventil 21 ist derart gestellt, dass die Bohrungen 10 und 11 verschlossen werden. Durch Stellen des Verstärkerventils 22 wird die Bodenfläche 20 des Verstärkerkolbens mit Druck beaufschlagt und dieser verfährt. Dabei baut sich gemäß dem Flächenverhältnis der Bodenfläche 20 zur Stimfläche 18 der Enddruck in dem abgeschlossenen Zylinderraum 3 auf, und an der Dichtung 23 wird über den Arbeitskolben 1 der erforderliche Anpressdruck der Stirnfläche 18 an den Behälter 9 erzeugt.

Nach dem Ende des Lastzyklusses wird das Verstärkerventil 22 geöffnet und der Zylinderraum 4 entspannt, wobei das Arbeitsmedium des Druckverstärkers 2 in die Atmosphäre entlassen wird. Nachfolgend wird das Arbeitsventil 21 so gestellt, dass der Zylinderraum 5 wasserhydraulisch mit Druck beaufschlagt wird, so dass der Arbeitskolben 1 synchron mit dem Verstärkerkolben 2 in Ausgangsposition verfährt.

Der Zyklus startet erneut aus der Position "Geöffneter Behälter" (Fig. 2), indem durch Stellung des Arbeitsventils 21 Arbeitsmedium durch die Bohrung 10 in den Zylinderraum 3 geleitet wird.

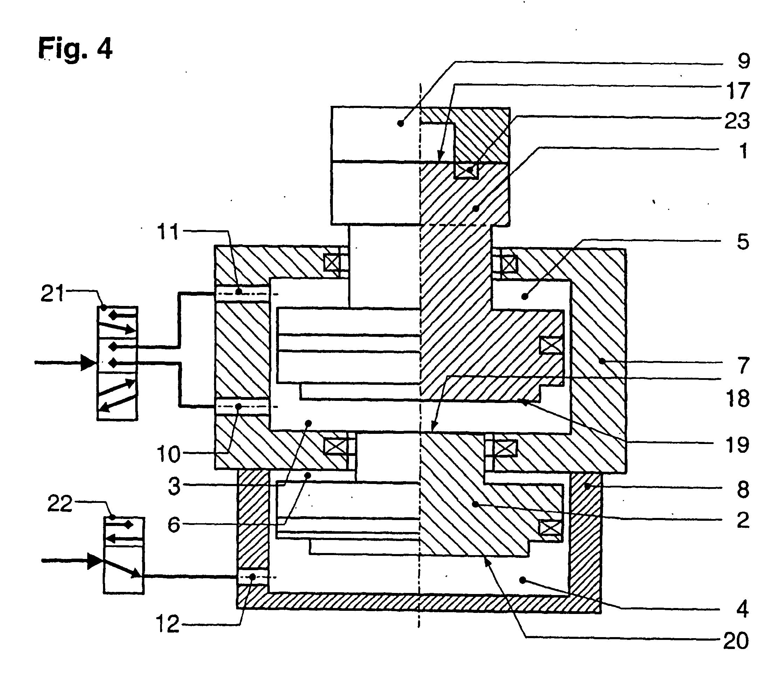

Besonders vorteilhaft in Bezug auf den Stand der Technik ist die Abhängigkeit des Druckverstärkers 2 vom Rückstelllauf des Arbeitskolbens 1. Durch diese Kopplulng entfällt das Erfordernis, eine separate Rückstellung des Verstärkerkolbens 2 und eine genaue Taktung der Ventile vorzusehen. Vorteilhafterweise ist ebenfalls die Ventilstellung zu Beginn des Lastzyklusses weitgehend entkoppelt. Für die anfängliche Druckbeaufschlagung im Zylinderraum 3 kann Verstärkerventil 22 in der Stellung verbleiben, die bei Lastende geschaltet war (Position "Verriegelter Behälter"; Fig. 4). Verglichen zu bekannten Systemen, wurde durch Synchronisierung der Kolbenrückstellung, Entkopplung der Ventilstellungen zum Beginn des Lastzyklusses sowie sehr kurze Hubwege erreicht, dass die Vorrichtung keine aufwändige Steuerung erfordert und besonders für schnelle Lastwechsel und hohe Drücke geeignet ist.

Verglichen mit bekannten Systemen werden mechanische Schäden werden weitgehend dadurch verhindert, dass eine indirekte Kraftübertragung vom Verstärkerkolben über die Fluidbrücke im Zylinderraum 3 zum Arbeitskolben realisiert ist. Diese wird sichergestellt, indem die Zylinderräume 5 und 6 in der Kolbenendstellung Position "Geschlossener Behälter" nicht vollständig entleert werden und somit die Oberflächen der Kolben die Zylinderwandung axial in Hubrichtung nie direkt berühren. Das selbe gilt auch für die Stirnfläche des Verstärkerkolbens in Bezug auf die Bodenfläche des Arbeitskolbens.

Besonders vorteilhaft verglichen mit bekannten Hubsystemen ist die sanfte Fahrweise des hydraulisch betriebenen Arbeitskolbens 1, so dass Dichtungen 25 und 27 nur gering belastet werden. In der Endstellung des Arbeitskolbens 1 beim Einsetzen der Endkraft über den Druckverstärker 2, erfolgt keine Relativbewegung mehr zwischen der Dichtfläche und der Kolbenwandung 13 und 15. Mögliche Emissionen, die von den Dichtungen 24 und 26 herrühren, werden in den Zylinderräumen 3, 4 und 6 Zurückgehalten und über die Bohrungen 10, 12 und 24 beim normalen Arbeitszyklus abgeführt. Ein zusätzliches Teilvakuum ist nicht erforderlich und somit ist bezogen auf den Stand der Technik eine wesentlicher Vorteil erreicht worden.

Bezugszeichenliste
- 1: Arbeitskolben
- 2: Verstärkerkolben
- 3: Zylinderzwischenraum
- 4: Zylinderraum
- 5: Zylinderraum
- 6: Zylinderraum
- 7: Arbeitszylinder
- 8: Verstärkerzylinder
- 9: Druckbehälter
- 10: Bohrung
- 11: Bohrung
- 12: Bohrung
- 13: Gleitfläche
- 14: Gleitfläche
- 15: Gleitfläche
- 16: Gleitfläche
- 17: Stirnfläche des Arbeitskolbens
- 18: Stirnfläche des Verstärkerkolbens
- 19: Bodenfläche des Arbeitskolbens
- 20: Bodenfläche des Verstärkerkolbens
- 21: Arbeitsventil
- 22: Verstärkerventil
- 23: Dichtung
- 24: Dichtung
- 25: Dichtung
- 26: Dichtung
- 27: Dichtung

## Patentansprüche

1. Hubsystem für Reinraumanwendungen zum Verschließen eines mindestens aus einem Basisteil und einem Verschlussteil bestehenden Behälters, welches mindestens einem bewegten Arbeitskolben 1 mit je einem Arbeitszylinder 7 und mindestens einem bewegten Verstärkerkolben 2 mit ebenfalls je einem Verstärkerzylinder 8 umfasst, alle rotationssymmetrisch, wobei Arbeitskolben 1 und dessen Arbeitszylinder 7 sowie Verstärkerkolben 2 und dessen Verstärkerzylinder 8 entlang einer Rotationsachse angeordnet sind, und der Arbeitskolben 1 an dem im Arbeitszylinder 7 befindlichen Kolbenende mindestens eine auf der äußeren Oberfläche radial umlaufende Verstärkung aufweist, so dass der Innenraum zwischen Arbeitszylinder 7 und Arbeitskolben 1 in mindestens zwei Hohlräume 3 und 5 geteilt wird, und mindestens eine Bohrung 10 und 11 im Arbeitszylinder 7 zu jedem dieser Hohlräume führt, wobei der Arbeitskolben 1 hydraulisch und der Verstärkerkolben 2 pneumatisch angetrieben werden, wobei
- Arbeitskolben 1 und Verstärkerkolben 2 über das Fluid, welches sich in einem Hohlraum 3 zwischen Bodenfläche 19 des Arbeitskolbens 1 und Stirnseite 18 des Verstärkerkolbens 2 befindet, bezüglich der Rotationsachse in direkter axialer Wirkverbindung stehen, wobei
- die Stirnseite des Arbeitskolbens 1 mindestens zum Teil der Verschluss des Behälters 9 ist oder starr mit einem Verschlussteil des Behälters 9 verbunden ist und
- dieses Verschlussteil bezogen auf den Arbeitskolben 1 ebenfalls im Wesenttichen entlang der Rotationsachse verfahren wird und der Behälter 9 gegenüber der Stirnseite des Arbeitskolbens 1 angeordnet ist, und an der Stirnfläche des Arbeitskolbens regelmäßig ein Arbeitsdruck über 180 bar erreicht wird,
**dadurch gekennzeichnet, dass** der Arbeitskolben derart gestaltet ist, dass
- das Hydraulikfluid Wasser ist
- mindestens eine der Gleitflächen 13 bis 16. welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, ein Tragverhältnis über 60 % aufweist, wobei das Tragverhältnis das Verhältnis des Anteils der Erhebungen zum Anteil der Vertiefungen in der Oberflächenstruktur ist,
- und das Kolbensystem hinsichtlich der Zu- und Ableitung der Antiebsmedien offen ist.

2. Vorrichtung nach Anspruch 1, **dadurch gekennzeichnet, dass** mindestens eine der Gleitflächen 13 bis 16, welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, gehärtet ist.

3. Vorrichtung nach einem der Ansprüche 1 oder 2, **dadurch gekennzeichnet, dass** durch
■ die Stellung eines Arbeitsventils 21, welches die Be- und Entleerung der Zylinderräume 3 und 5 des Arbeitszylinders 7 regelt, die Bodenfläche 19 des Arbeitskolbens 1 mit Fluid beaufschlagt wird, indem über mindestens eine Druckleitung und die Bohrungen 10 Fluid in den Hohlraum 3 zwischen Stirnfläche 18 des Verstärkerkolbens 2 und Bodenfläche 19 des Arbeitskolbens 1 geleitet wird, und somit
■ der Arbeitskolben aus der Ausgangsposition *"Nicht-geschlossener Behälter"* in die Vorpressposition *"Geschlossener Behälter"* gefahren wird und den Behälter 9 verschließt,
■ das Arbeitsventil 21 anschließend derart geschaltet wird, dass alle Leitungswege zu den Bohrungen 10 und 11, die dem Arbeitszylinder 7 des Arbeitskolbens 1 zugeordnet sind, verschlossen werden, und durch das nachfolgende
■ Schalten eines Verstärkerventils 22, welches die Be- und Entleerung der Zylinderräume 4 und 6 des Verstärkerkolbens regelt, die Bodenfläche 20 des Verstärkerkolbens 2 mit Fluid beaufschlagt wird, indem über mindestens eine Druckleitung und die Bohrungen 12 in der Zylinderwand Fluid in den Zylinderraum 4 unterhalb der Bodenfläche 20 des Verstärkerkolbens 2 geleitet wird, und somit
■ der Verstärkerkolben 2 in die Endposition *"Verriegelter Behälter"* verfahren wird und diese Position *"Verriegelter Behälter"* für eine beliebige Zeitdauer gehalten wird, anschließend
■ das Verstärkerventil 22 geöffnet und das Fluid im Zylinderraum 4 unterhalb der Bodenfläche 20 des Verstärkerkolbens 2 entspannt wird, und nachfolgend
■ das Arbeitsventil 21 so gestellt wird, dass über mindestens eine Druckleitung und die Bohrung 11 der obere Hohlraum 5 des Arbeitszylinders 7 des Arbeitskolbens 1 mit Fluid beaufschlagt wird und der Druck auf die der Bodenfläche 19 des Arbeitszylinders 1 gegenüberliegende und im Wesentlichen parallele und im Wesentlichen ringförmige Fläche der Kolbenverstärkung wirkt, so dass der Arbeitskolben 1 in die Ausgangsposition "Offener Behälter" verfährt, wobei
■ das Fluid, welches im Hohlraum unterhalb dem Arbeitskolben 1 eingeschlossen ist, auf die Stimfläche 18 des Verstärkerkolbens 2 einwirkt und diesen ebenfalls in die Ausgangsposition verfährt.

4. Vorrichtung, nach einem der Ansprüche 1 bis 3, **dadurch gekennzeichnet, dass** statt Wasser als Fluid in den Räumen des Arbeitszylinders 7 des Arbeitskolbens 1 ein leichtflüchtiges Medium aus der Gruppe verwendet wird, die durch Ethanol, Methanol, Isopropanol, und vergleichbare Stoffe oder Mischungen daraus gebildet- ist, oder ein Gas verwendet wird, welches im Wesentlichen aus CO₂, Sauerstoff, Stickstoff, einem Edelgas oder Mischungen daraus besteht.

5. Vorrichtung nach einem der Ansprüche 1 bis 4, **dadurch gekennzeichnet, dass** als Fluid in den Räumen 4 und 6 des Verstärkerzylinders 8 des Verstärkerkolbens 2 ein leichtflüchtiges Medium aus der Gruppe verwendet wird, die durch Ethanol, Methanol, Isopropanol, und vergleichbare Stoffe oder Mischungen daraus gebildet ist, oder ein Gas verwendet wird, weiches im Wesentlichen aus CO₂, Sauerstoff, Stickstoff, einem Edelgas oder Mischungen daraus besteht.

6. Vorrichtung nach einem der Ansprüche 1 bis 5, **dadurch gekennzeichnet, dass** in dem Behälter 9 regelmäßig ein Druck über 180 bar erreicht wird.

7. Verwendung der Vorrichtung nach einem der Ansprüche 1 bis 6, **dadurch gekennzeichnet, dass** die Vorrichtung im Zusammenhang mit einer Anwendung, Produktion oder einem Verfahren der Halbleiterindustrie und/oder Waferherstellung eingesetzt wird.

8. Verwendung der Vorrichtung nach einem der Ansprüche 1 bis 6, **dadurch gekennzeichnet, dass** die Vorrichtung im Zusammenhang mit einer Anwendung, Produktion oder einem Verfahren der optischen Industrie eingesetzt wird.

9. Verwendung der Vorrichtung nach einem der Ansprüche 1 bis 6, **dadurch gekennzeichnet, dass** die Vorrichtung im Zusammenhang mit einer Anwendung, Produktion oder einem Verfahren der pharmazeutischen oder

10. Vorrichtung zum Pressen oder Verformen mindestens eines Halbzeugs mittels eines rotationssymmetrischen Hubsystems für Reinraumanwendungen, bestehend aus mindestens einem bewegten Arbeitskolben 1 mit je einem Arbeitszylinder 7 und mindestens einem bewegten Verstärkerkolben 2 mit ebenfalls je einem Verstärkerrytinder 8, alle rotationssymmetrisch, wobei Arbeitskolben 1 und dessen Arbeitszylinder 7 sowie Verstärkerkolben 2 und dessen Verstärkerzylinder 8 entlang je einer Rotationsachse angeordnet sind, und der Arbeitskolben 1 an dem im Arbeitszylinder 2 befindlichen Kolbenende mindestens eine auf der äußeren Oberfläche radial umlaufende Verstärkung aufweist, so dass der Innenraum zwischen Arbeitszylinder 7 und Arbeitskolben 1 in mindestens zwei Hohlräume 3 und 5 geteilt wird, und mindestens eine Bohrung 10 und 11 im Arbeitszylinder 7 zu jedem dieser Hohlräume 3 und 5 führt, wobei der Arbeitskolben 1 hydraulisch und der Verstärkerkolben 2 pneumatisch angetrieben werden, wobei der Arbeitskolben 1 hydraulisch und der Verstärkerkolben 2 pneumatisch angetrieben werden an wobei
- Arbeitskolben 1 und Verstärkerkolben 2 über das Fluid, welches sich in einem Hohlraum 3 zwischen Bodenfläche 19 des Arbeitskolbens 1 und Stirnseite 18 des Verstärkerkolbens 2 befindet, bezüglich der Rotationsachse in direkter axialer Wirkverbindung stehen, wobei die Stirnseite des Arbeitskolbens 1 mindestens zum Teil das Press- oder Verformungswerkzeug ist oder starr mit einem Press- oder Verformungswerkzeug verbunden ist und dieses Press- oder Verformungswerkzeug bezogen auf den Arbeitskolben 1 ebenfalls im Wesentlichen entlang der Rotationsachse verfahren wird und das Halbzeug gegenüber der Stirnseite 17 des Arbeitskolbens 1 angeordnet ist, und
**dadurch gekennzeichnet, dass**
- das Hydraulikfluid Wasser ist, an der Stirnfläche, des Arbeitskolbens regelmäßig ein Arbeitsdruck über 180 bar erreicht wird,
- mindestens eine der Gleitflächen 13 bis 16. welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, ein Tragverhältnis über 60% aufweist, wobei das Tragverhältnis das Verhältnis des Anteils der Erhebungen zum Anteil der Vertiefungen in der Oberflächenstruktur ist.

11. Vorrichtung nach Anspruch 10, **dadurch gekennzeichnet, dass** mindestens eine der Gleitflächen, welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, gehärtet ist.

12. Vorrichtung nach Anspruch 10 oder 11, **dadurch gekennzeichnet, dass** durch
■ die Stellung eines Arbeitsventils 21, welches die Be- und Entleerung der Zylinderräume 3 und 5 des Arbeitszylinders 7 regelt, die Bodenfläche 19 des Arbeitskolbens 1 mit Fluid beaufschlagt wird, indem über mindestens eine Druckleitung und die Bohrung 10 Fluid in den Hohlraum zwischen Stimfläche 18 des Verstärkerkolbens 2 und Bodenfläche 19 des Arbeitskolbens 1 geleitet wird, und somit
■ der Arbeitskolben aus der Ausgangsposition *"Nicht-berührtes Halbzeug"* in die Vorpressposition *"Berührtes Halbzeug"* gefahren wird,
■ das Arbeitsventil 21 anschließend derart geschaltet wird, dass alle Leitungswege zu den Bohrungen 10 und 11, die dem Arbeitszylinder 7 des Arbeitskolbens 1 zugeordnet sind, verschlossen werden, und durch das nachfolgende
■ Schalten eines Verstärkerventils 22, welches die Be- und Entleerung der Zylinderräume 4 und 6 des Verstärkerkolbens 2 regelt, die Bodenfläche 20 des Verstärkerkolbens 2 mit Fluid beaufschlagt wird, indem über mindestens eine Druckleitung und die Bohrung 12 in der Zylinderwand Fluid in den Zylinderraum 4 unterhalb der Bodenfläche 20 des Verstärkerkolbens 2 geleitet wird, und somit
■ der Verstärkerkolben 2 in die Endposition *"Gepresstes Halbzeug"* verfahren wird und diese Position *"Gepresstes Halbzeug"* für eine beliebige Zeitdauer gehalten wird, anschließend.
■ das Verstärkerventil 22 geöffnet und das Fluid im Zylinderraum 4 unterhalb der Bodenfläche 20 des Verstärkerkolbens 2 entspannt wird, und nachfolgend
■ das Arbeitsventil 21 so gestellt wird, dass über mindestens eine Druckleitung und die Bohrung 11 der obere Hohlraum 5 des Arbeitszylinders 7 des Arbeitskolbens 1 mit Fluid beaufschlagt wird und der Druck auf die der Bodenfläche 19 des Arbeitszylinders 1 gegenüberliegende und im Wesentlichen parallele und im Wesentlichen ringförmige Fläche der Kolbenverstärkung wirkt, so dass der Arbeitskolben 1 in die Ausgangsposition *"Nicht-berührtes Halbzeug"* verfährt, wobei
■ das Fluid, welches im Hohlraum 3 unterhalb dem Arbeitskolben 1 eingeschlossen ist, auf die Stirnfläche 18 des Verstärkerkolbens 2 einwirkt und diesen ebenfalls in die Ausgangsposition verfährt.

13. Vorrichtung nach einem der Ansprüche 10 bis 12, **dadurch gekennzeichnet, dass** als Fluid in den Räumen 3 und 5 des Arbeitszylinders 7 des Arbeitskolbens 1 ein leichtflüchtiges Medium aus der Gruppe verwendet wird, die durch Ethanol, Methanol, Isopropanol, und vergleichbare Stoffe oder Mischungen daraus gebildet ist, oder ein Gas verwendet wird, welches im Wesentlichen aus CO₂, Sauerstoff, Stickstoff, einem Edelgas oder Mischungen daraus besteht.

14. Vorrichtung nach einem der Ansprüche 10 oder 13, **dadurch gekennzeichnet, dass** statt Wasser als Fluid in den Räumen 4 und 6 des Verstärkerzylinders 8 des Verstärkerkolbens 2 ein leichtflüchtiges Medium aus der Gruppe verwendet wird, die durch Ethanol, Methanol, Isopropanol, und vergleichbare Stoffe oder Mischungen daraus gebildet ist, oder ein Gas verwendet wird, welches im Wesentlichen aus CO₂, Sauerstoff, Stickstoff, einem Edelgas oder Mischungen daraus besteht.

15. Verwendung der Vorrichtung nach einem der Ansprüche 10 bis 14, **dadurch gekennzeichnet, dass** die Vorrichtung im Zusammenhang mit einer Anwendung. Produktion oder einem Verfahren der Halbleiterindustrie und/oder Waferherstellung eingesetzt wird.

16. Verwendung der Vorrichtung nach einem der Ansprüche 10 bis 14, **dadurch gekennzeichnet, dass** die Vorrichtung im Zusammenhang mit einer Anwendung, Produktion oder einem Verfahren der optischen Industrie eingesetzt wird.

17. Verwendung der Vorrichtung nach einem der Ansprüche 10 bis 14, **dadurch gekennzeichnet, dass** die Vorrichtung im Zusammenhang mit einer Anwendung, Produktion oder einem Verfahren der pharmazeutischen oder medizinisch-pharmazeutischen Industrie eingesetzt wird.

## Claims

1. Reciprocating piston device suitable for clean-room applications and for the closure of a vessel and consisting of at least one base element and one closure element, said system encompassing at least one movable piston (1) with one hydraulic cylinder each (7), and at least one movable intensifier piston (2) also combined with one intensifier cylinder each (8), all of which are rotationally symmetrical, hydraulic piston (1) and its hydraulic cylinder (7) and intensifier piston (2) and its intensifier cylinder (8), each being arranged along an axis of rotation and hydraulic piston (1) featuring on its piston end in the hydraulic cylinder (7) at least one circumferential reinforcement running radially on its outer surface, with the result that the internal space between hydraulic cylinder (7) and hydraulic piston (1) is divided into at least two subsidiary spaces (3) and (5), and at least one bore (10) and (11) in hydraulic cylinder (7) leading to each of these subsidiary spaces, the cylinder (1) being driven water-hydraulically and the intensifier piston (2) pneumatically, hydraulic piston (1) and intensifier piston (2) being incorporated into a direct axial function in relation to the axis of rotation, via the fluid located in space (3) between lower face (19) of piston (1) and upper face (18) of intensifier piston (2), the upper face of hydraulic piston (1) forming at least part of the closure of vessel (9) or being rigidly connected to the closure part of vessel (9), and the said closure part essentially moving along the axis of rotation in relation to hydraulic piston (1), too, and vessel (9) being arranged opposite the upper face of hydraulic piston (1), **characterized in that**
- the hydraulic piston is designed such that an operating pressure of >180 bars is regularly achievable at the face of the hydraulic piston,
- water is the hydraulic fluid,
- at least one of the sliding surfaces (13 to 16) arranged on the internal surfaces of the cylinders and on the piston surfaces in the zones, in which the cylinder and piston surfaces are located opposed to one another and in contact and move relative to one another parallel to the axis of rotation, exhibits a support ratio of >60 %, said ratio representing the proportion of "peaks" to the "valleys" of the surface structure, and
- the reciprocating piston system is open with regard to the feed and discharge of the operating fluid.

2. Device in accordance with the claim 1,
**characterized in that** at least one of the sliding surfaces arranged on the internal surfaces of the cylinder and the piston surfaces in the zones in which the cylinder and piston surfaces are located opposed to one another and are in contact and moved relative to one another parallel to the axis of rotation is hardened.

3. Device for operating of the device in accordance with one of the preceding claims 1 or 2, **characterized in that**
■ the position of a hydraulic valve (21), which controls the feed and discharge of cylinder chambers (3 and 5) of hydraulic cylinder (7), causes feeding of fluid to lower face (19) of hydraulic piston (1) by feeding, via not less than one delivery line and bores (10), of fluid into space (3) between upper face (18) of intensifier piston (2) and lower face (19) of hydraulic piston (1), and
■ thus moves the hydraulic piston from the *"vessel open"* starting position to the *"vessel closed"* pre-pressurising position and closing vessel (9),
■ hydraulic valve (21) then moving in such a way that all routes to bores (10 and 11) assigned to hydraulic cylinder (7) of hydraulic piston (1) are closed and
■ the subsequent positioning of intensifier valve (22), which controls the feed and discharge of the cylinder chambers (4) and (6) of intensifier piston, causing fluid to be applied to lower face (20) of intensifier piston (2) by the feeding, via not less than one delivery line and bores (12) in the cylinder wall, of fluid into cylinder chamber (4) below lower face (20) of intensifier piston (2) and
■ intensifier piston (2) therefore moving to the *"vessel locked"* end position and the said position being maintained for any period of time required,
■ intensifier valve (22) then being opened and the fluid in cylinder chamber (4) below lower face (20) of intensifier piston (2) being depressurized and
■ subsequently hydraulic valve (21) being positioned in such a way that via at least one delivery line and bore (11) fluid is fed into upper space (5) in hydraulic cylinder (7) of hydraulic piston (1) and the pressure acting on the essentially annular and essentially parallel surface of the circumferential piston reinforcement located opposite the lower face (19) of hydraulic cylinder (1) in such a way that hydraulic piston (1) moves to its "vessel open" starting position,
■ the fluid, which is enclosed in the space underneath hydraulic piston (1), thereby acting on upper face (18) of intensifier piston (2) and moving this, too, into its starting position.

4. Device in accordance with one of the preceding claims 1 to 3, **characterized in that** a readily volatile fluid from the group formed by ethanol, methanol, isopropanol and similar substances or mixtures, is used as the fluid in the spaces formed by hydraulic cylinder (7) of hydraulic piston (1), or that a gas consisting essentially of CO₂, oxygen, nitrogen, a noble gas or mixtures thereof is used as the fluid in the said spaces.

5. Device in accordance with one of the preceding claims 1 to 4, **characterized in that** a readily volatile fluid from the group formed by ethanol, methanol, isopropanol and similar substances or mixtures thereof, is used as the fluid in spaces (4) and (6) formed by intensifier cylinder (8) of intensifier piston (2) or that a gas consisting essentially of CO₂, oxygen, nitrogen, a noble gas or mixtures thereof is used as the fluid in the said spaces.

6. Device in accordance with one of the preceding claims 1 to 5, **characterized in that** a pressure of >180 bars is regularly reached in vessel (9).

7. Utilization of the device in accordance with one of the preceding claims 1 to 6,
**characterized in that** the device is used in conjunction with an application, production operation or process in the semiconductor and/or wafer production industries.

8. Utilization of the device in accordance with one of the preceding claims 1 to 6,
**characterized in that** the device is used in conjunction with an application, production operation or a process in the optics industry.

9. Utilization of the device in accordance with one of the preceding claims 1 to 6,
**characterized in that** the device is used in conjunction with an application, production operation or a process in the pharmaceuticals industry and/or medical and medicinal products industries.

10. Device for pressing or forming of at least one semi-finished product by means of a rotation-symmetric reciprocating piston mechanism, consisting of not less than one hydraulic piston (1) each with a hydraulic cylinder (7), and not less than one moving intensifier piston (2) each with an intensifier cylinder (8), all rotationally symmetrical, hydraulic piston (1) and its hydraulic cylinder (7) and intensifier piston (2) and its intensifier cylinder (8) each being arranged along an axis of rotation, and the hydraulic piston end located in the hydraulic cylinder having not less than one circumferential reinforcement running radially on the external surface, such that the internal space between hydraulic cylinder (7) and hydraulic piston (1) is divided into at least two subsidiary chambers (3) and (5), and at least one bore (10) and (11) in hydraulic cylinder (7) leading to each of these subsidiary chambers (3) and (5), hydraulic piston (1) being actuated water-hydraulically and intensifier piston (2) pneumatically, hydraulic piston (1) and intensifier piston (2) form a direct axial functional unit with one another relative to the axis of rotation, with the aid of a fluid which is located in a space (3) between lower face (19) of hydraulic cylinder (1) and upper face (18) of intensifier piston (2), the upper face of hydraulic piston (1) at least partially forming the pressing or forming tool or being rigidly connected to a pressing or forming tool and this pressing or forming tool essentially moving along the axis of rotation relative to hydraulic piston (1) and the semi-finished product being located opposite the upper face (17) of hydraulic piston (1), **characterized in that**
- the hydraulic piston is designed such that an operating pressure of >180 bars is regularly achievable at the face of the hydraulic piston,
- water is the hydraulic fluid,
- at least one of the sliding surfaces (13 to 16) arranged on the internal surfaces of the cylinders and on the piston surfaces in the zones in which the cylinder and piston surfaces are located opposed to one another and in contact and move relative to one another parallel to the axis of rotation, exhibits a support ratio of >60 %, said ratio representing the proportion of elevations ("peaks") to the depressions ("valleys") of the surface structure.

11. Device in accordance with one of the claim 10,
**characterized in that** at least one of the sliding surfaces located on the internal cylinder surfaces and on the piston surfaces in the zones in which the cylinder and piston surfaces are located opposite one another and are in contact and moved parallel to the axis of rotation, is hardened.

12. Device in accordance with one of the preceding claims 10 or 11,
**characterized in that**
■ the positioning of a hydraulic valve (21) which controls the feed and discharge of cylinder chambers (3) and (5) of hydraulic cylinder (7) causes feeding of fluid to the lower face (19) of hydraulic piston (1), by feeding of fluid via not less than one delivery line and bore (10) into the space between upper face (18) of intensifier piston (2) and lower face (19) of hydraulic piston (1) and,
■ thus, movement of the hydraulic piston from its *"no product contact"* starting position into its *"product contact"* pre-pressurising position,
■ valve (21) subsequently being moved in such a way that all paths to bores (10) and (11) assigned to hydraulic cylinder (7) of hydraulic piston (1) are closed and
■ by subsequent setting of intensifier valve (22), which controls the feed and discharge of cylinder chambers (4) and (6) of intensifier piston (2), feeding of fluid to lower face (20) of intensifier piston (2) occurs, by feeding of fluid via not less than one delivery line and bore (12) in the cylinder wall into cylinder chamber (4) below lower face (20) of intensifier piston (2), and
■ therefore intensifier piston (2) to be moved to its *"pressed product"* end position and this *"pressed product"* position to be retained for any period of time required,
■ intensifier valve (22) then being opened and the fluid in cylinder chamber (4) below lower face (20) of intensifier piston (2) being depressurized, and
■ hydraulic valve (21) then being positioned in such a way that fluid is fed via not less than one delivery line and bore (11) to upper space (5) of hydraulic cylinder (7) of hydraulic piston (1) and the pressure acting on the essentially annular and essentially parallel surface area of the circumferential reinforcement located opposite the lower face (19) of hydraulic cylinder (1) in such a way that hydraulic piston (1) moves into its *"no product contact"* starting position,
■ the fluid enclosed in space (3) below hydraulic piston (1) acting on upper face (18) of intensifier piston (2) and moving this, too, into its starting position.

13. Device in accordance with the preceding claims 10 to 12,
**characterized in that** a readily volatile fluid taken from the group formed by ethanol, methanol, isopropanol and similar substances or mixtures thereof is used as the fluid in the chamber (3) and (5) formed by hydraulic cylinder (7) and its hydraulic piston (1) or that a gas consisting essentially of CO₂, oxygen, nitrogen, a noble gas or mixtures thereof is used as the fluid in the said chambers.

14. Device in accordance with one of the preceding claims 10 or 13,
**characterized in that** a readily volatile fluid taken from the group formed by ethanol, methanol, isopropanol and similar substances or mixtures thereof is used as the fluid in chambers (4) and (6) formed by intensifier cylinder (8) and its intensifier piston (2) or that a gas consisting essentially of CO₂, oxygen, nitrogen, a noble gas or mixtures thereof is used as the fluid in the said chambers.

15. Utilization of the device in accordance with one of the preceding claims 10 to 14,
**characterized in that** the device is used in conjunction with an application, production operation or a process in the semiconductor and/or wafer production industries.

16. Utilization of the device in accordance with one of the preceding claims 10 to 14,
**characterized in that** the device is used in conjunction with an application, production operation or a process in the optics industry.

17. Utilization of the device in accordance with one of the preceding claims 10 to 14,
**characterized in that** the device is used in conjunction with an application, production operation or a process in the pharmaceuticals industry and/or medical and medicinal products industries.

## Revendications

1. Mécanisme à piston alternatif approprié aux applications en régime de salle blanche (clean room) et étudié pour la fermeture d'un récipient, et qui consiste au minimum en une partie de base et une partie de fermeture avec, au moins, un piston hydraulique mobile (1) lié à un vérin hydraulique (7) et avec, au moins, un piston intensificateur (2) lié également à un vérin intensificateur (8), tous du type symétrique par rapport à la rotation, et que l'extrémité du dit piston hydraulique
(1) dans le vérin hydraulique (7) est dotée, au minimum, d'un renfort radial et circonférenciel et disposée sur la surface extérieure, de telle sorte que l'espace intérieure qui se trouve entre le vérin hydrauliqe (7) et le piston hydraulique (1) soit divisée, au minimum, en deux chambres creuses (3 et 5), et que au moins un alésage (10) ou (11) soit disposé dans le vérin hydraulique (7) et branché sur l'une des dites chambres creuses, le piston 1 étant actionné de manière hydraulique et le piston intensificateur de manière pneumatique, et que le piston hydraulique (1) et le piston intensificateur (2) soient incorporés directement dans une fonction axiale par rapport à l'axe de rotation, à l'aide du fluide qui se situe dans l'espace (3) entre l'extrémité inférieure (19) du piston (1) et l'extrémité supérieure (18) du piston intensificateur (2), l'extrémité supérieure (18) du piston hydraulique (1) faisant au moins partie de l'outil de pressage ou formage ou étant fermement connectée au dit outil qui se déplace principalement le long de l'axe de rotation, par rapport au piston hydraulique (1), et que le produit demi-fini soit disposé visà-vis de l'extrémité supérieure (17) du piston hydraulique (1),
**caractérisé en ce que**
- le piston hydraulique a été mis au point de telle sorte que la pression de régime de >180 bars soit régulièrement réalisable à l'extrémité du piston hydraulique,
- que le fluide hydraulique est de l'eau,
- que, au minimum, une des surfaces de glissement (13 à 16), qui se situent sur la paroi intérieure du vérin et sur les surfaces respectives du piston, dans la zone
où les surfaces du vérin et du piston se touchent comme des éléments membres du dit mécanisme en position vis-à-vis et se déplacent parallèlement à l'axe de rotation, atteint un rapport d'appui de plus de 60 %, c.-à-d. la structure correpond au rapport entre la partie des élévations (peaks) et celle des vallées (valleys).

2. Dispositif selon la revendication 1,
**caractérisé en ce que**, au minimum, une des surfaces de glissement 13 à 16, qui se situe sur la paroi intérieure du vérin et sur les surfaces respectives du piston, dans la zone où les surfaces du vérin et du piston se touchent en position vis-à-vis et se déplacent parallèlement à l'axe de rotation, est sousmise à un procédé de durcissement.

3. Dispositif selon l'une des revendications 1 ou 2, **caractérisé en ce que**
■ la position de la vanne hydraulique (21), qui contrôle l'alimentation en et l'écoulement du fluide des chambres (3 et 5) du vérin hydraulique (7), cause la mise sous pression de l'extrémité inférieure (19) du piston hydraulique (1) par l'amenée, à travers au minimum une conduite de refoulement et les alésages (10), du fluide vers l'espace (3) qui se situe entre l'extrémité (18) du piston intensificateur (2) et l'extrémité (19) du piston hydraulique (1), et
■ que le piston hydraulique se déplace alors depuis la position de départ «Récipient non fermé» vers la position de pilotage «Récipient fermé» et fait donc fermer le récipient (9),
■ que la commutation de la vanne hydraulique (21) a lieu de telle sorte que toutes les conduites vers les alésages (10 et 11) branchés sur le vérin hydraulique (7) du piston hydraulique (1) soient fermés et
■ que la commutation d'une vanne intensificatrice (22), qui contrôle l'alimentation en et l'écoulement du fluide des chambres (4) et (6) du piston intensificateur, cause la mise sous pression de l'extrémité 20 du piston intensificateur, par l'amenée, à travers au minimum une conduite de refoulement et les alésages (20) dans la paroi du vérin, du fluide vers la chambre (4) qui se situe au-dessous de l'extrémité inférieure (20) du piston intensificateur (2) et
■ que, de cette manière, le piston intensificateur (2) se déplace vers la position extrême «Récipient fermé», dans laquelle le dit piston puisse s'arrêter pendant toute durée voulue;
■ par conséquent, la vanne intensificatrice (22) s'ouvre et le fluide dans la chambre 4 au-dessous de l'extrémité (20) du piston intensificateur (2) subit une détente et
■ le positionnement ultérieur de la vanne hydraulique (21) est de telle sorte que par l'amenée du fluide, à travers au minimum une conduite de refoulement et l'alésage (11), provoque une mise sous pression de la chambre supérieure (5) dans le vérin hydraulique (7) du piston hydraulique (1) et une montée de la pression sur la surface, qui est essentiellement circonférencielle et parallèle du renfort et qui se trouve vis-à-vis de l'extrémité inférieure (19) du vérin hydraulique (1), de manière que le piston hydraulique (1) se déplace vers la position de départ «Récipient ouvert», et
■ que le fluide renfermé dans l'espace (3) au-dessous du piston hydraulique (1) provoque une poussée sur l'extrémité (18) du piston intensificateur (2) et ainsi le déplacement de ce dernier vers sa position de départ.

4. Dispositif selon l'une des revendications de 1 à 3,
**caractérisé en ce que** l'on utilise, au lieu de l'eau, dans les chambres du vérin hydraulique (7) du piston hydraulique (1), un fluide facilement volatile qui tire son origine du groupe constitué par l'éthanol, le méthanol, l'isopropanol, ou bien des mélanges de ceux-ci, ou alternativement du gaz essentiellement composé de CO₂, oxygène, nitrogène, gaz rare ou bien des mélanges de ceux-ci.

5. Dispositif selon l'une des revendications de 1 à 4,
**caractérisé en ce que** l'on utilise, dans les espaces (4) et (6) qui se situent dans le vérin intensificateur (8) du piston intensificateur (2), un fluide facilement volatile qui tire son origine du groupe constitué par l'éthanol, le méthanol, l'isopropanol,
ou bien des mélanges de ceux-ci, ou alternativement du gaz essentiellement composé de CO₂, oxygène, nitrogène, gaz rare ou bien des mélanges de ceux-ci.

6. Dispositif selon l'une des revendications de 1 à 5,
**caractérisé en ce que** la pression de >180 bars est régulièrement réalisable dans le récipient (9).

7. Mise en oeuvre du dispositif selon l'une des revendications de 1 à 6,
**caractérisé en ce que** le dit dispositif est utilisé dans une combinaison avec une application, production ou procédure réalisée dans les industries des semiconducteurs et/ou la production de microchips.

8. Mise en oeuvre du dispositif selon l'une des revendications de 1 à 6,
**caractérisé en ce que** le dit dispositif est utilisé dans une combinaison avec une application, production ou procédure réalisée dans les industries optiques.

9. Mise en oeuvre du dispositif selon l'une des revendications de 1 à 6,
**caractérisé en ce que** le dit dispositif est utilisé en combinaison avec une application, production ou procédure réalisée dans les industries pharmaceutiques ou médico-pharmaceutiques.

10. Dispositif pour le pressage ou formage d'au moins un produit demi-fini, à l'aide d'un mécanisme à piston alternatif et symmétrique par rapport à l'axe de rotation, qui consiste au minimum en un piston hydraulique mobile (1) lié à un vérin hydraulique (7) et avec, au moins, un piston intensificateur (2) lié également à un vérin intensificateur (8), tous du type symmétrique par rapport à la rotation, et que l'extrémité du dit piston hydraulique (1) dans le vérin hydraulique (7) est dotée, au minimum, d'un renfort radial et corconférenciel et disposée sur la surface extérieure, de telle sorte que l'espace intérieure qui se trouve entre le vérin hydrauliqe (7) et le piston hydraulique (1) soit divisée, au minimum, en deux chambres creuses (3 et 5) et que, au moins, un alésage (10) ou (11) soit disposé dans le vérin hydraulique (7) et branché sur l'une des dites chambres creuses, le piston 1 étant actionné de manière hydraulique et le piston intensificateur de manière pneumatique, et que le piston hydraulique (1) et le piston intensificateur (2) soient incorporés directement dans une fonction active par rapport à l'axe de rotation, à l'aide du fluide qui se situe dans l'une des espaces (3) entre l'extrémité inférieure (19) du piston (1) et l'extrémité supérieure (18) du piston intensificateur (2), que l'extrémité supérieure du piston hydraulique (1) porte au moins une partie du jeu d'outils de pressage ou formage ou que le dit jeu d'outils se déplace, par rapport au piston hydraulique (1), essentiellement le long de l'axe de rotation et que le produit demi-fini se trouve vis-à-vis de l'extrémité (17) du piston hydraulique (1), **caractérisé en ce que**
- le piston hydraulique a été mis au point de telle sorte que la pression de régime de >180 bars soit régulièrement réalisable à l'extrémité du piston hydraulique,
- le fluide hydraulique est de l'eau,
- que, au minimum, une des surfaces de glissement (13 à 16), qui se situent sur la paroi intérieure du vérin et sur les surfaces respectives du piston, dans la zone où les surfaces du vérin et du piston se touchent comme des éléments membres du dit mécanisme en position vis-à-vis et se déplacent parallèlement à l'axe de rotation, atteint un rapport d'appui de plus de 60 %, c.-à-d. la structure correpond au rapport entre la partie des élévations (peaks) et celle des vallées (valleys).

11. Dispositif selon la revendication 10,
**caractérisé en ce que**, au minimum, l'une des surfaces de glissement, qui se situe sur la paroi intérieure du vérin et sur les surfaces respectives du piston, dans la zone où les surfaces du vérin et du piston se touchent en position vis-à-vis et se déplacent parallèlement à l'axe de rotation, est sousmise à un procédé de durcissement.

12. Dispositif selon l'une des revendication 10 ou 11,
**caractérisé en ce que**
■ la position de la vanne hydraulique (21), qui contrôle l'alimentation en et l'écoulement du fluide des chambres (3 et 5) du vérin hydraulique (7), provoque la mise sous pression de l'extrémité inférieure (19) du piston hydraulique (1) par l'amenée, à travers au minimum une conduite de refoulement et les alésages (10), du fluide vers l'espace (3), qui se situe entre l'extrémité (18) du piston intensificateur (2) et l'extrémité (19) du piston hydraulique (1), et
■ c'est pourquoi le piston hydraulique se déplace alors depuis la position de départ «Produit demi-fini non touché» vers la position de pilotage «Produit demi-fini touché»,
■ que la commutation de la vanne hydraulique (21) a lieu de telle sorte que toutes les conduites vers les alésages (10) et (11) branchés sur le vérin hydraulique (7) du piston hydraulique (1) sont fermées et
■ que la commutation d'une vanne intensificatrice (22), qui contrôle l'alimentation en et l'écoulement du fluide des chambres (4) et (6) du piston intensificateur, provoque la mise sous pression de l'extrémité 20 du piston intensificateur, par l'amenée, à travers au minimum une conduite de refoulement et les alésages (20) dans la paroi du vérin, du fluide vers la chambre (4) qui se situe au-dessous de l'extrémité inférieure (20) du piston intensificateur (2) et
■ que, de cette manière, le piston intensificateur (2) se déplace vers la position extrême «Produit demi-fini pressé» dans laquelle le dit piston puisse s'arrêter pendant toute durée voulue;
■ par conséquent, la vanne intensificatrice (22) s'ouvre et le fluide dans la chambre (4) au-dessous de l'extrémité 20 du piston intensificateur (2) subit une détente et
■ le positionnement ultérieur de la vanne hydraulique (21) est de telle sorte que par l'amenée du fluide, à travers au minimum une conduite de refoulement et l'alésage (11), provoque une mise sous pression de la chambre supérieure (5) dans le vérin hydraulique (7) du piston hydraulique (1) et une montée de la pression sur la surface, qui est essentiellement circonférencielle et parallèle du renfort et qui se trouve vis-à-vis de l'extrémité inférieure (19) du vérin hydraulique (1), de manière que le piston hydraulique (1) se déplace vers la position de départ «Produit demi-fini non touché», et
■ que le fluide renfermé dans l'espace (3) au-dessous du piston hydraulique (1) provoque une poussée sur l'extrémité (18) du piston intensificateur (2) et ainsi le déplacement de ce dernier vers sa position de départ.

13. Dispositif selon l'une des revendications de 10 à 12,
**caractérisé en ce que** l'on utilise, dans les espaces (3 et (5) qui se situent dans le vérin hydraulique (7) du piston hydraulique (1), un fluide facilement volatile qui tire son origine du groupe constitué par l'éthanol, le méthanol, l'isopropanol, ou bien des mélanges de ceux-ci, ou alternativement du gaz essentiellement composé de CO₂, oxygène, nitrogène, gaz rare ou bien des mélanges de ceux-ci.

14. Dispositif selon l'une des revendications de 10 à 13,
**caractérisé en ce que** l'on utilise, au lieu de l'eau, dans les espaces (4) et (6) qui se situent dans le vérin intensificateur (8) du piston intensificateur (2), un fluide facilement volatile qui tire son origine du groupe constitué par l'éthanol, le méthanol, l'isopropanol, ou bien des mélanges de ceux-ci, ou alternativement du gaz essentiellement composé de CO₂, oxygène, nitrogène, gaz rare ou bien des mélanges de ceux-ci.

15. Mise en oeuvre du dispositif selon l'une des revendications de 10 à 14,
**caractérisé en ce que** le dit dispositif est utilisé dans une combinaison avec une application, production ou procédure réalisée dans les industries des semiconducteurs et/ou la production de microchips.

16. Mise en oeuvre du dispositif selon l'une des revendications de 10 à 14,
**caractérisé en ce que** le dit dispositif est utilisé dans une combinaison avec une application, production ou procédure réalisée dans les industries des industries optiques.

17. Mise en oeuvre du dispositif selon l'une des revendications de 10 à 14,
**caractérisé en ce que** le dit dispositif est utilisé dans une combinaison, production ou procédure réalisée dans les industries pharmaceutiques ou médico-pharmaceutiques.
